# EUROPEAN PATENT SPECIFICATION

(11) **EP 1 729 892 B1**
(45) Date of publication and mention of the grant of the patent: **17.06.2009**
(21) Application number: 05728587.6
(22) Date of filing: 30.03.2005
(51) Int. Cl.: B05D 3/14, B05D 7/24, H05H 1/24

(54) **METHOD FOR COATING A SUBSTRATE USING DIELECTRIC BARRIER DISCHARGE**
VERFAHREN ZUM BESCHICHTEN EINES SUBSTRATS UNTER VERWENDUNG EINER DIELEKTRISCHEN BARRIEREENTLADUNG
PROCEDE DE REVETEMENT D'UN SUBSTRAT AU MOYEN D'UNE DECHARGE CONTROLEE PAR BARRIERE DIELECTRIQUE

(30) Priority: 31.03.2004 EP 04007735
(43) Date of publication of application: 13.12.2006
(73) Proprietor: Vlaamse Instelling voor Technologisch Onderzoek (VITO), 2400 Mol (BE); Fraunhofer-Gesellschaft zur Förderung der angewandten Forschung e.V., 80686 München (DE)
(72) Inventor: ROSE, Klaus, 97318 KITZINGEN (DE); PAULUSSEN, Sabine Johanna Alouis, B-2018 ANTWERPEN (BE); REGO, Robby Jozef Martin, B-2440 GEEL (BE); HAVERMANS, Danny, B-2340 BEERSE (BE); COOLS, Jan Jozef, B-2490 BALEN (BE); VANGENEUGDEN, Dirk Leo, B-3630 MAASMECHELEN (BE)
(74) Representative: pronovem
(86) International application number: PCT/BE2005/000043
(87) International publication number: WO 2005/095007

(56) References cited:
- EP-A- 1 073 091
- WO-A-20/04028220
- US-A- 5 523 124
- US-A1- 2002 182 319
- US-A1- 2003 104 140
- US-B1- 6 664 737

## Description

### Field of the Invention

The present invention relates to a method of coating a substrate material and materials so coated. In particular in one embodiment the method comprises atmospheric plasma curing of a hybrid polymer material.

### State of the art

In many applications the mechanical, chemical or physical properties of surfaces of materials play an important role. If, for any reason, the requirements can not be met by the bulk of the material, the application of coatings and surface modification is a convenient method in order to improve the properties. In this way many substrates can be refined and used in new applications. A very simple case is the refinement by coating with decorative and coloured layers. But in many cases and for special applications also other functional properties have to be improved, e. g. hardness, chemical resistance, electrical resistivity, barrier properties or optical appearance.

Increasing demands on new materials caused also growing interest in inorganic-organic hybrid materials with the potential to combine the inherent properties of inorganic materials with those of organic polymers as described in B. M. Novak, Adv. Mater. 5 (1993) 6. The classical approach has been the development of composite materials or blends, where at least two different phases with complementary properties were mixed. But since an optimised combination of properties can only be expected by a direct and optimised linkage between the two materials, the desired synergistic effects were not always achieved, due to incompatibility or phase separation.

A more powerful method in order to design new hybrid materials is the combination of inorganic and organic/polymeric structural units on a molecular scale by chemical synthesis. The sol-gel process has been established as a versatile method for the preparation of new inorganic-organic hybrid materials. It is described in for example : U. Schubert, N. Hüsing, A. Lorenz, Chem. Mater. 7 (1995) 2010 or C. J. Brinker, G. Scherer, Sol-Gel-Science, The Physics and Chemistry of Sol-Gel, Processing, Academic Press (1990).

Since the synthesis is carried out in aqueous/alcoholic media the resulting solution can be used as a lacquer in order to apply the hybrid material onto substrates for the improvement of the surface properties. Inorganic-organic hybrid polymer coating materials (such as those available under the registered trade mark ORMOCER^{®}s ) allow a wide range of possible combinations and variations of inorganic and organic groups or structural elements and tailoring. And for this reason they are superior to commonly used organic coating materials.

Standard industrial coating technologies comprise the application of a lacquer followed by thermal or UV-induced curing treatment. In addition to these atmospheric pressure based techniques vacuum techniques like CVD, PVD or low pressure plasma are more and more used. Advantages of the ambient pressure methods are that they can be used with standard and inexpensive coating and curing equipment. Vacuum methods are often related to higher costs concerning equipment and processing and they give only very thin layers. Therefore, in metallisation processes and coating of small substrates, e.g. ophthalmic lenses, these methods have been established.

The following disadvantages of commonly used materials and technologies are evident:
Commonly used organic coating materials do not exhibit this high degree of cross-linking which is necessary for a high mechanical stability, scratch and abrasion resistance and for a high network density resulting in good barrier properties.
In order to meet these requirements organic coatings have to be used with inorganic particles/fillers [4] or in multilayer compositions.
Even hybrid materials exhibit high barrier properties only in multilayer compositions with SiOₓ or AlOₓ [5]

Thermal curing needs a long time at elevated temperatures in order to achieve effective cross-linking. High temperatures are harmful to a lot of commonly used plastic substrates and long curing times are disadvantageous for fast in-line production processes. UV curing occurs mainly at the top of the coating. In the case of thick layers a decreasing degree of cross-linking into the depth of the layer is often observed.

Low pressure plasma or CVD and PVD give highly cross-linked films but only thin layers in the .nm range. This layer thickness is too low for excellent mechanical stability (scratch and abrasion resistance) or high barrier properties and the methods are too expensive for large scale applications.

Classical curing methods do not utilize the full potential of the hybrid materials, whereas due to their low vapor pressure in the liquid phase they can not be used in vacuum techniques. Document US6664737 is related to a dielectric barrier discharge apparatus for treating a substrate, wherein the apparatus comprises a porous planar electrode. US2002/182319 is related to a method for depositing a coating on the wall of metallic containers, however not in combination with organic/inorganic cross-linked pre-polymers. US2003/0104140. does refer to organic/inorganic block polymers, however not to materials synthesized by sol-gel chemistry. US5523124 is related to the use of hydrosilane chemical precursors for coating deposition. These compounds can't be hyrdolized and used in sol-gel preparation.

Therefore, atmospheric pressure plasma technology has been developed to circumvent the need for expensive and limited volume equipment of low pressure plasma. The use of this method in combination with hybrid polymer coating materials and their inherent properties is promising, since this synergistic effect will lead to coating materials with excellent and unique properties. It is an object of the invention to solve some of all of the problems with the prior art.

### Summary of the invention

The present invention is related to a method and apparatus as described in the appended claims.

### Short description of the figures

Fig. 1 shows a schematic drawing of an apparatus according to the invention.

Fig. 2 illustrates the improved effect of the method of the invention on the oxygen permeation of coatings.

Fig. 3 and 4 illustrate additional examples of the improved oxygen transmission rate of coatings obtained by the method of the invention.

### Detailed description of the invention

A method and apparatus for generating and maintaining a plasma is now described. When chemical compounds are introduced into a plasma discharge, chemically active species are formed such as molecules in excited states, radicals and ions. These species can react with each other, with neutral molecules or with the surface of a substrate. Depending on the nature of the compounds and the process conditions, this may result in cleaning, etching, chemical surface modification (often referred to as activation), deposition of a thin film (often referred to as plasma assisted coating deposition) or the formation of new chemical compounds in the form of gases, liquids or (nano sized) powders.

The type of plasma discharge wherein at least one electrode is covered by an electrically insulating material, is called "Dielectric Barrier Discharge" (DBD). Dielectric barrier discharges offer interesting perspectives for cost effective in-line plasma treatments. The configuration of a DBD apparatus generally comprises one or more sets of two electrodes of which at least one is covered with an insulating (dielectric) material. The equipment is especially interesting for innovative surface modification and coating deposition. For this purpose, various organic, inorganic or hybrid (organic/inorganic) precursors can be used. If not gaseous, these precursors are generally applied in the form of vapours of (heated) liquids, aerosols or (nano sized) particles.

The invention comprises the use of inorganic-organic hybrid polymers as liquid coating material (precursor solution) with an atmospheric aerosol assisted plasma process for film curing.

The principle of the formation of inorganic-organic hybrid polymers via sol-gel processing is the hydrolysis and condensation of organically functionalized alkoxysilanes. The sol-gel synthesis of precursor solutions is outlined below. 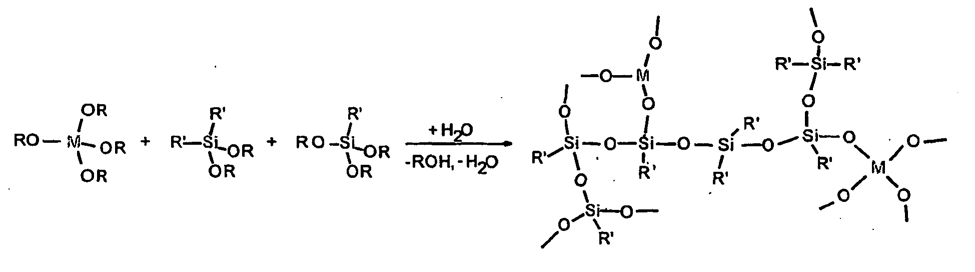 where R' = non-reactive/functional or reactive/polymerizable group, R = Me, Et, M = Si, Ti, Zr... As a result of this reaction an inorganic, silica-like network or silicone-like chain as prepolymer is formed bearing functional organic groups R'.

The combination of organically substituted alkoxysilanes with alkoxy compounds of metals, e.g. Si(OEt)₄, Ti(OEt) ₄, Zr(OPr)₄, Al(O^{s}Bu)₃ will modify the inorganic part of the material by formation of the corresponding metal oxide structure. In this way very hard and highly densified materials are available which can be used as scratch resistant or barrier coatings.

Examples of precursors for the formation of a pure inorganic glass-like or ceramic-like network are as follows: 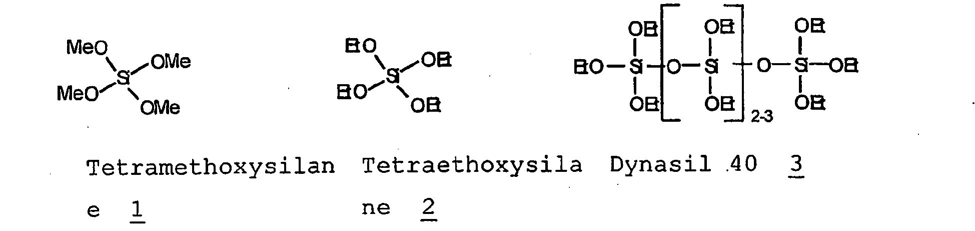 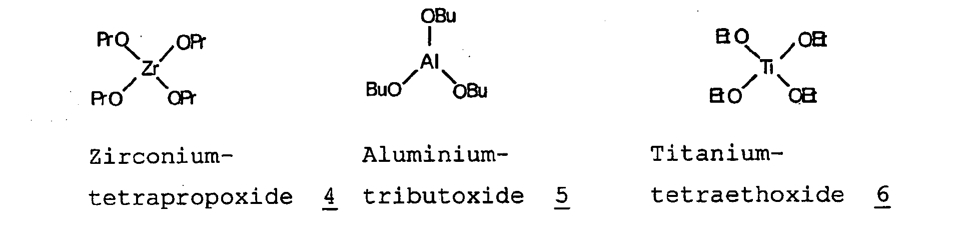 The monomer compounds for the formation of a pure inorganic network may bear an organic complex ligand like acetic acid ethyl ester or methacrylic acid: 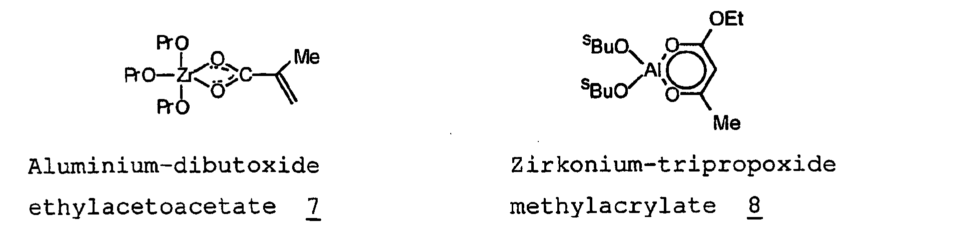 It is also possible to use an oligomer siloxane as inorganic crosslinker:

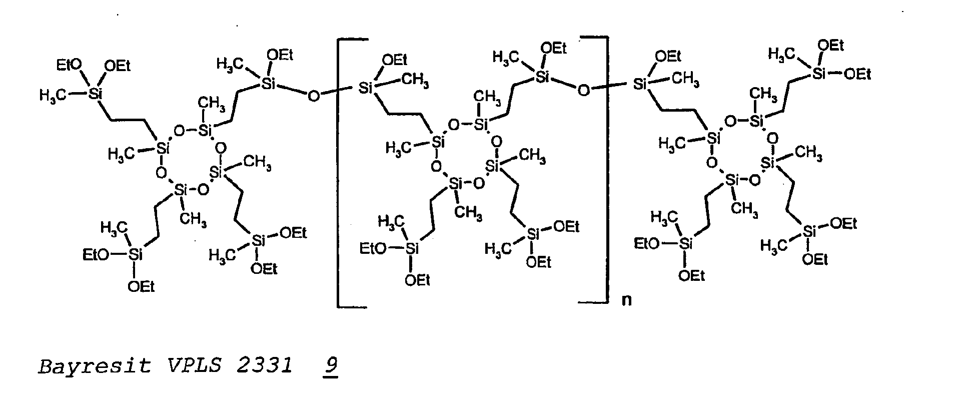

The invention is in particular related to the method of appended claim 1, wherein organic/inorganic hybrid pre-polymer is obtained or obtainable from Bayresit VPLS 2331, with the above formula, wherein n is a positive integer. Non-reactive groups R' act as network modifiers suitable for network functionalisation in order to introduce chemical properties to the coating. Examples of organically functionalised alkoxysilanes are given below:

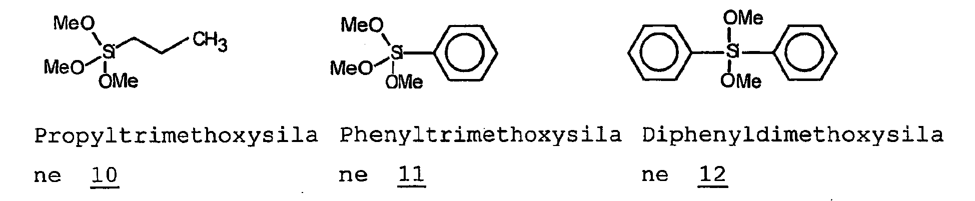

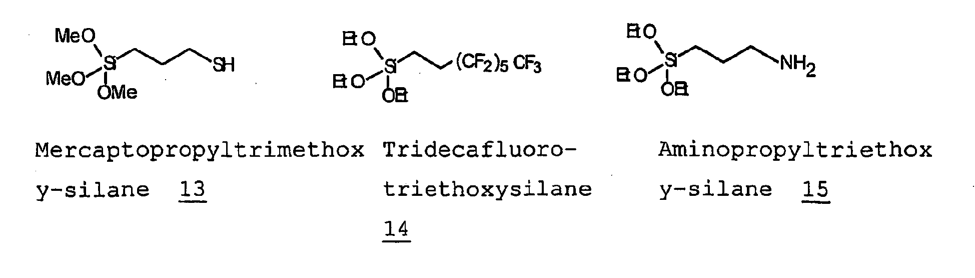

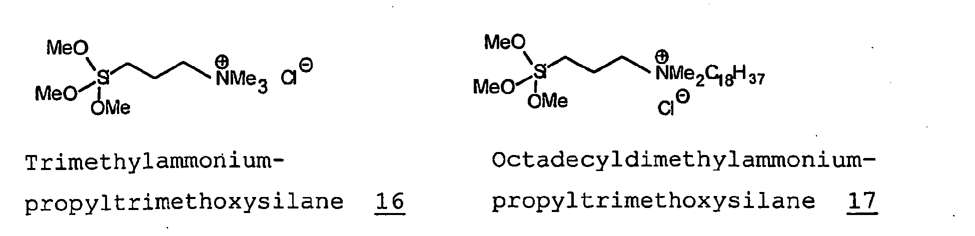

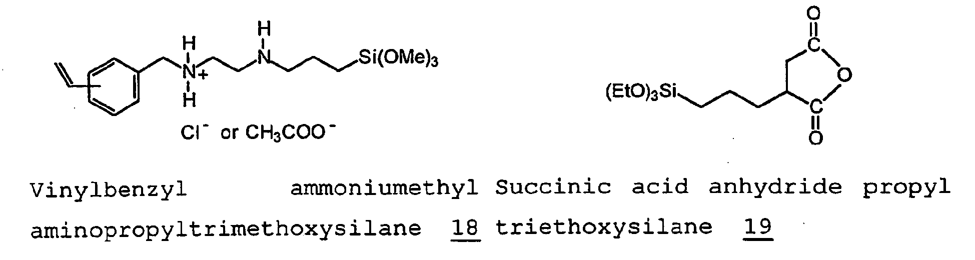

In the case of reactive groups R` an additional organic polymer network can be formed by polymerization reactions of the reactive groups. Examples of monomer silanes with reactive groups are as follows:

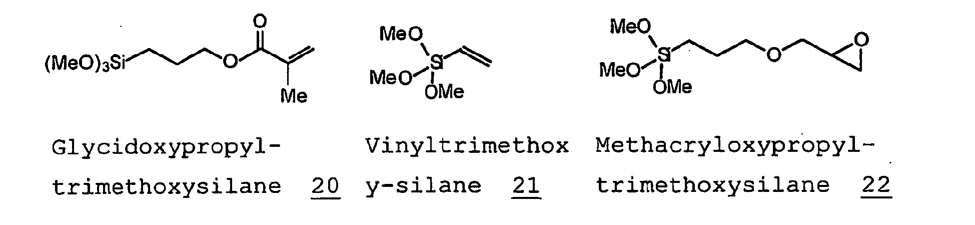

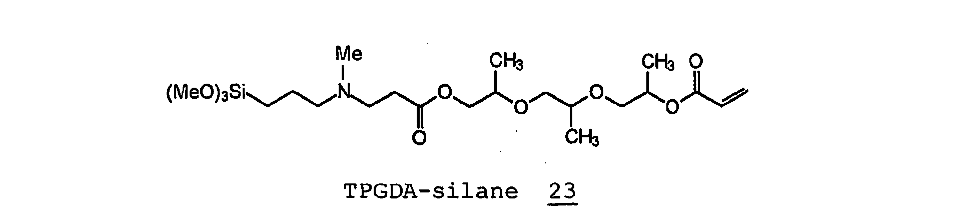

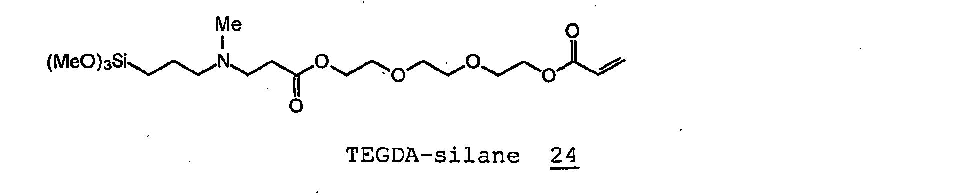

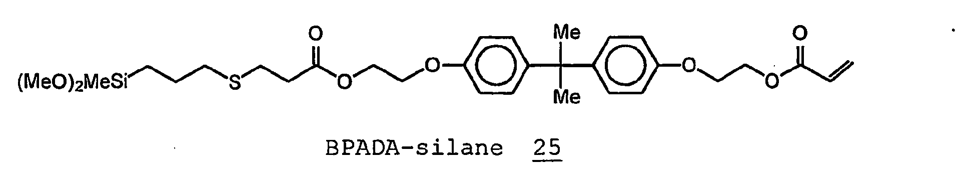

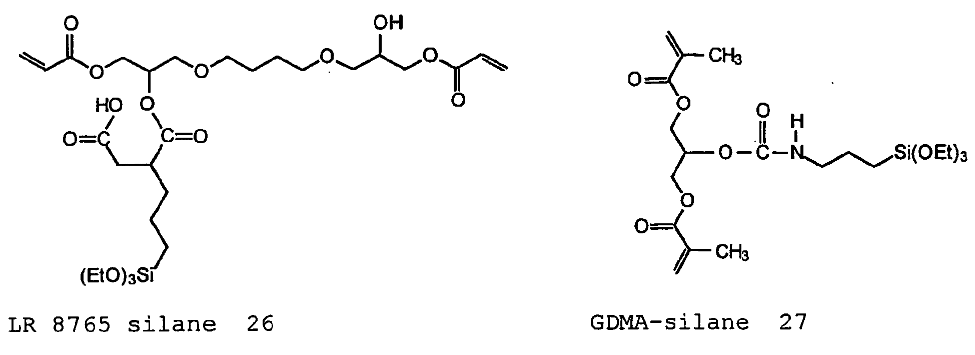

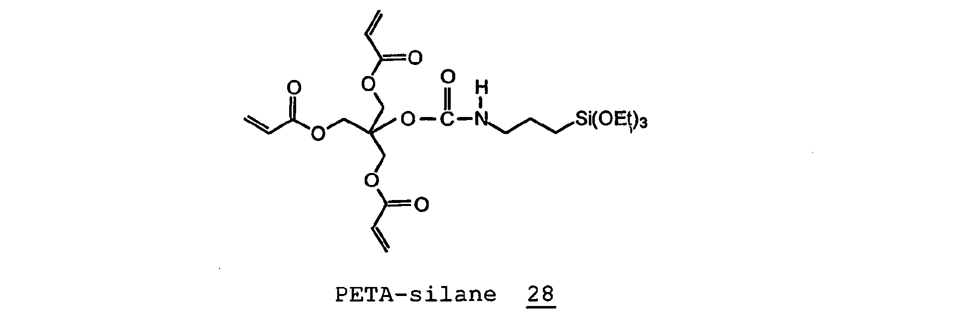

In the method of the invention one or more of the following compounds may be added to the mixture of cross-linked inorganic-organic hybrid pre-polymer used in the sol-gel system before aerosol formation:
organic coating forming materials; optionally carboxylates, methacrylates, acrylates, styrenes, methacrylonitriles, alkenes and dienes, more optionally methyl (meth)acrylate, ethyl (meth)acrylate, propyl (meth)acrylate, butyl (meth)acrylate and/or other alkyl (meth)acrylates, organofunctional (meth)acrylates, glycidyl methacrylate, trimethoxysilyl propyl methacrylate, allyl methacrylate, hydroxyethyl methacrylate, hydroxypropyl methacrylate, dialkylaminoalkyl methacrylates, and fluoroalkyl (meth) acrylates, methacrylic acid, acrylic acid, fumaric acid and esters, itaconic acid (and esters), maleic anhydride, styrene, α-methylstyrene, halogenated alkenes, for example, vinyl halides, such as vinyl chlorides and vinyl fluorides, and fluorinated alkenes, for example perfluoroalkenes, acrylonitrile, methacrylonitrile, ethylene, propylene, allyl amine, vinylidene halides, butadienes, acrylamide, such as N-isopropylacrylamide, methacrylamide, epoxy compounds, for example glycidoxypropyltrimethoxysilane, glycidol, styrene oxide, butadiene monoxide, ethyleneglycol diglycidylether, glycidyl methacrylate, bisphenol A diglycidylether (and its oligomers), vinylcyclohexene oxide and phosphorus-containing compounds, for example dimethylallylphosphonate. Additional inorganic coating forming materials which can be added include colloidal metals and metal oxides and organometallic compounds.

In the method of the invention the inorganic-organic hybrid coating may be obtained and/or obtainable by mixing separately in additional to the aerosol in step d) one or more additional gases, vapours, aerosols or powders of the following compounds to the plasma discharge: Ar, He, O₂, N₂, CO₂, CO, SF₆, NO, NO₂, N₂O, H₂, methane, ethane, propane, butane, ethylene, propylene, ethylene oxide, propylene oxide, acetylene, CF₄, C₂F₆, C₂F₄, H₂O and/or any of the ingredients described herein.

Under plasma conditions radicals are generated. Radicals are known to initiate the polymerization of vinyl-, methacryl- or acryl double bonds as well as bond cleavage or ring opening reactions. The radical fragments formed by the latter mechanisms are also able to polymerize and recombine thus also forming an organic network.

Coatings obtained from alkoxysilane precursors with reactive acrylic or epoxy groups showed similar results after plasma and UV-curing (acrylics) or thermal curing (epoxide), respectively. Spectroscopic data indicate that atmospheric plasma also initiates radical polymerization (acrylics) or ring opening and polymerization (epoxide) as it is known from conventional curing.

Coatings from precursors with non-reactive aliphatic groups, were tack-free and solid after plasma processing, whereas after thermal curing they were still sticky. This result and spectroscopic data indicate that organic cross-linking probably via fragmentation and chain formation as well as inorganic (siloxane-) network formation occur simultaneously during the plasma process. Polymers functionalised to be suitable for use in the present invention (for example those sold under the trade mark ORMOCER^{®}) may be synthesised as follows:
the polymer is silylated with suitable alkoxysilane monomer(s);
the silylated polymers undergo a sol-gel-reaction with functional silane precursors to form a solution of an inorganic-organic hybrid polymer which can be used as described herein in the plasma process. The reaction is shown schematically below 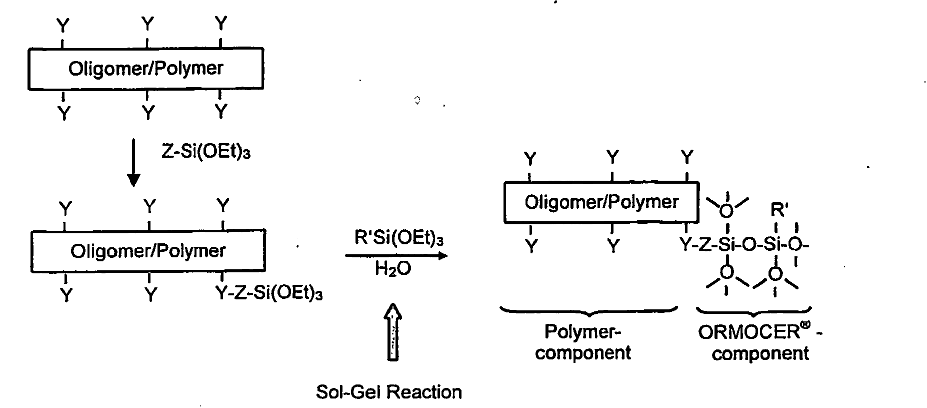
where Y denotes a functional group on the polymer to be used for reaction with a functional group on the alkoxysilanes for the modification/silylation of the polymer;
Z: denotes a functional group for attaching the alkoxysilane to the polymer; and
R':denotes a non reactive/functional or reactive polymerizable group.

Some preferred reactions for linking silane monomers to polymers are: 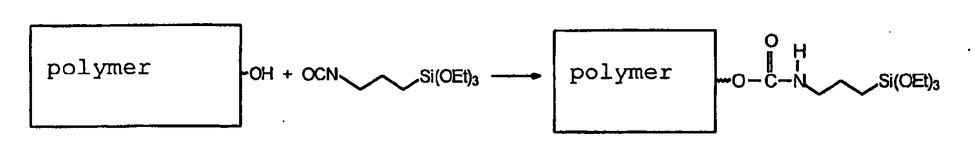 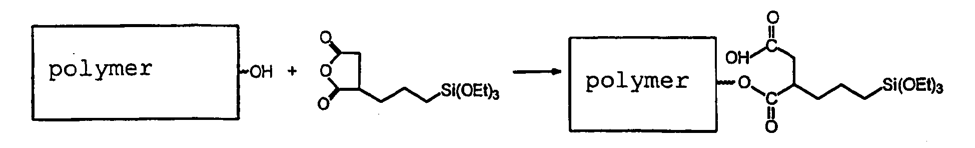 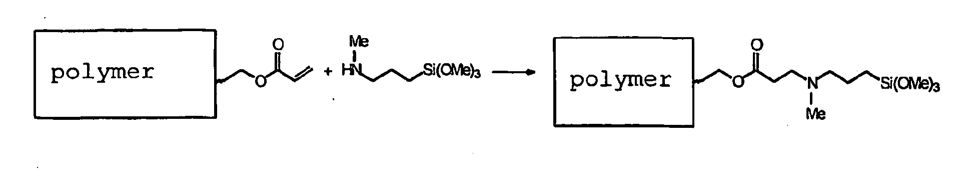 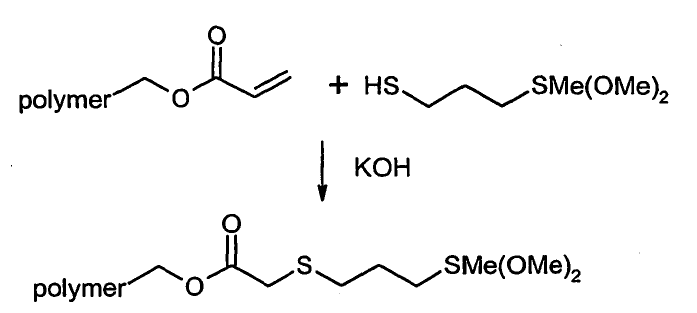 Other preferred reactions are epoxy groups with amino groups to form polymer-epoxy with amino silane groups or vice versa.
As used herein (meth)acrylate denotes methacrylate and acrylate moities.

The methods described herein have the advantage that the polymers to be functionalised can be selected to have the desired inherent properties (such as flexibility, conductivity, hydrophilicity) which after functionalisation are then introduced into the hybrid material.

The process includes the injection of the film forming precursor as an aerosol via atomization into the plasma volume adjacent to the base substrate (Aerosol Assisted Atmospheric Plasma: AAAP). The influence of the plasma on the aerosol droplets of the coating material will enhance their reactivity thus improving cross-linking and curing results. Limitations due to film thickness are also reduced. This effect can be additionally improved by decreasing the size of the droplets to the nano-scale. A nano-sized aerosol will be generated by an electrospray process which offers control on aerosol diameter and charge.

The combination of the plasma process with designed hybrid polymers increases the performance of the resulting coatings significantly regarding curing behavior, degree of cross-linking and network density. In combination with the possibility of chemical functionalization of ORMOCER^{®}s the field of applications of these materials can be extended significantly. Moreover, the plasma can also have effects on functionalization of coatings and on adhesion.

It has been shown that plasma curing affects both inorganic and organic cross-linking in the hybrid polymer precursors. This twofold effect of the plasma process both on organic and inorganic components of hybrid coating materials is superior to that of conventional curing with respect to the degree of cross-linking and network density.

Coatings manufactured by the novel AAAP process in combination with hybrid coating materials used in an in-line production environment will exhibit better performance and increased functionality at reduced costs. Enhanced network density will increase particularly the mechanical stability and barrier properties of the produced films.
The process is not limited to specific kinds of substrate materials.

In the patent WO 02/28548 A2 an ambient pressure plasma process is described in combination with monomer alkoxysilanes of the general type R'Si(OEt)₃ and other organic monomers. The alkoxysilanes are used as monomers, i.e. without hydrolysation and without the formation of an inorganic prepolymer. The difference to the method described here is obvious and significant. When using monomers the degree of crosslinking is lower than in the case of prepolymers. And a high degree of crosslinking is necessary for high performance materials.

In another aspect of the present invention there is provided a method for generating and maintaining a plasma according to the Dielectric Barrier Discharge (DBD) technique, said method comprising the steps of :
a)- introducing a sample in the space between two electrodes,
b)- controlling the atmosphere between the electrodes,
c) generating a plasma discharge between the electrodes
d)- admixing aerosols containing hybrid organic/inorganic cross-linked pre-polymers, formed via sol-gel processing, to the plasma discharge.

According to the invention, said plasma can be maintained at a pressure in the range between 100Pa and 1MPa. According to a further embodiment, said plasma is maintained at a pressure in the range between 1000Pa and IMPa, preferably at atmospheric pressure.

Said atmosphere may additionally comprise one or more of the following components : gases, vapours, aerosols, powders. Said mixed atmosphere may exhibit a compositional gradient.

The invention is equally related to an apparatus for generating and maintaining a plasma, preferably in the pressure range between 100Pa and 1MPa, said apparatus comprising a pair of electrodes, a gap being present between said electrodes, and a voltage generator for applying a voltage between said electrodes, said electrodes consisting of an electrically conducting material, wherein one or both electrodes are covered with an electrically insulating material, characterized in that said generator is capable of generating an alternating voltage such as described herein. Furthermore, one or both electrodes may be temperature controlled and one or broth of the electrodes may be movable.

In an apparatus of the invention, said electrodes may have the form of planar or curved plates or grids, bars, cylinders, or knife or brush type geometries. One or both of said electrodes may be segmented in different parts of any shape. An apparatus of the invention may comprise a parallel and/or serial combination of one or more of said electrodes.

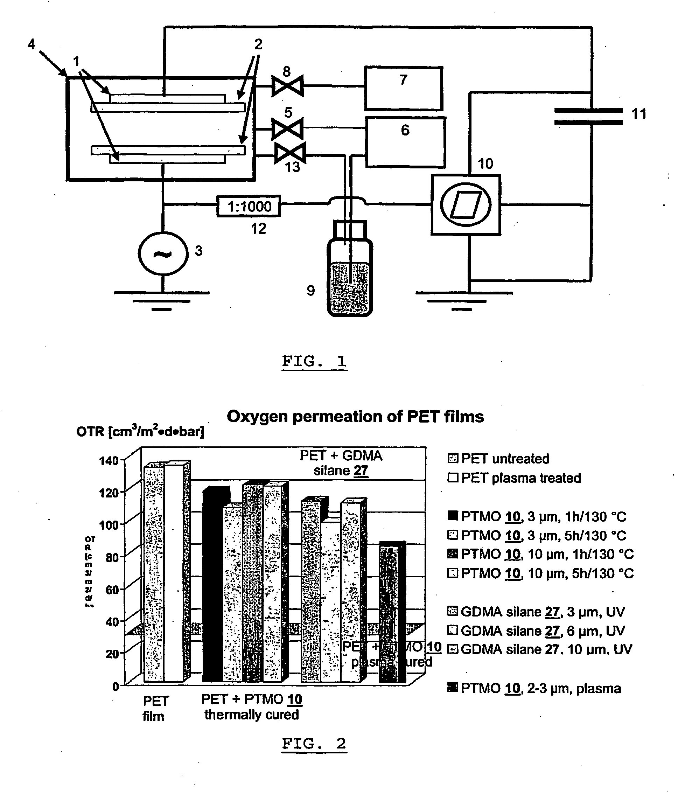

An embodiment of an apparatus in which the method according to the invention can be implemented is depicted in Figure 1. The apparatus (4) comprises a pump (7) to evacuate the gases, with a optional control valve (8). An inlet port with an optional control valve is provided both for the gases (5) coming from a gas supply unit (6) and the aerosols of hybrid organic/inorganic cross-linked prepolymers 13 coming from an aerosol generator 9. The apparatus also comprises at least one set of electrodes (1 and 2). The power supply (3) is connected to at least one of the electrodes. The other electrode can be grounded, connected to the power supply (3) or connected to a second power supply. Voltage, charge and current measurements can be performed by means of an oscilloscope (10). For this one can use respectively a voltage probe (12), a capacitor (11) and a current probe.

Any known generator capable of delivering a high voltage having a symmetrical or asymmetrical profile, can be used. Suitable generator are for example provided by Corona Designs.
Such an apparatus further comprises a pair of electrodes, a gap being present between the electrodes, wherein a mixed atmosphere is to be arranged in said gap.

The electrodes consist of an electrically conducting material and said electrodes can be constructed in any shape but preferentially will take the form of planar or curved plates or grids, bars, cylinders, knife or brush type geometries. One or both of said electrodes consists of an electrically conducting material covered with an electrically insulating material. Furthermore, one or both of said electrodes may be segmented in different parts of any shape. An apparatus of the invention may comprise a parallel and / or serial combination of one or more of said electrodes.

In an apparatus of the invention, at least one material may be placed between said electrodes. Said material can be a sample requiring a plasma treatment. Said sample can be an organic, inorganic or metallic foil, plate, fibre, wire or powder, a woven or non-woven textile or any combination thereof.

The plasma treatment conditions at each of the electrode surfaces and at the surfaces of any material placed between the electrodes can differ substantially from each other and can be controlled by the characteristics of the alternating current voltage applied to these electrodes.

The plasma treatment conditions can consist of any combination of following operations: etching, cleaning, activation or deposition.

One or both electrodes in an apparatus of the invention may be temperature controlled. Furthermore, one or both of the electrodes may be movable.

Further aspects and/or preferred features of the invention are described in the claims.

### EXAMPLES

By way of illustration only the following non-limiting examples are described, with reference to the numbered compounds previously.

Hybrid coatings based on precursor compounds bearing reactive or non-reactive groups were deposited by the AAAP process and compared with conventionally cured coatings.

After plasma treatment as well as after thermal curing (1h/100-200 °C) a precursor solution of **2** resulted in powder formation. This means that inorganic cross-linking due to condensation reaction is evident, also in plasma curing. In sol-gel derived systems this process is known to start only at higher temperatures with a duration in the range of hours. In the case of plasma curing this effect is remarkable since the plasma exposition occurs for several minutes at a lower temperature.

Transparent and homogeneous coatings were obtained from solutions of hydrolised **20** and **22** after plasma curing. In both cases organic cross-linking (**20**: ring opening and polymerization, **22:** radical initiated - C=C-polymerization) and inorganic cross-linking /condensation has occurred. The organic cross-linking/polymerization was observed via IR-spectroscopy. The spectra of **20** exhibit the formation of a carbonyl indicating the ring opening reaction. The spectra of **22** show a significant decrease of the -C=C-double bond (1640 cm⁻¹) indicating organic polymerization. The results are similar to those which have been obtained after thermal curing (**20:**1 h/130 °C) and UV curing, respectively (**22**: 20 s and 5,93 J/cm²).
In **10** no reactive organic polymerizable group is present, i. e. only condensation reactions are possible, in principle. The films obtained after plasma treatment were cured, whereas after thermal curing (1-5 h/130°C) the films were still sticky, i. e. not cured. This effect shows clearly that after thermal treatment only condensation has occurred, which is not as effective as in **2**. During plasma curing additional organic cross-linking has occurred leading to cured films as shown by IR spectroscopy. The IR spectrum of thermally cured **10** is identical to the non-cured film, whereas the spectrum of plasma cured **10** exhibits a carbonyl signal at 1695 cm⁻¹ indicating also oxidation reaction in the organic chain.
In order to confirm the effect of plasma curing on macroscopic properties, the oxygen permeability of coated PET films was determined. As can be seen in Figure 2, the oxygen permeability (expressed by the Oxygen Transmission Rate, OTR) decreases significantly from thermally cured **10** and UV cured **27** to plasma cured **10** coatings on PET films. The reason is the highly densified structure obtained only with plasma curing.

### ADDITIONAL EXAMPLE

The example involves combinations of Bayresit VPLS 2331 9 with the following silanes via sol-gel processing: Propyltrimethoxysilane 10, Glycidoxypropyl-trimethoxysilane 20, Methacryloxypropyl-trimethoxysilane 22, GDMA-silane 27.
Molar ratios of Bayresit/silane = 50:50 and 20:80.

### Application:

Alcoholic sols of Bayrecit/silane compositions were coated on polypropylene (PP58) and polyester (Arylite^{®}) via :
a) Doctor blade and subsequent thermal curing (130 °C/1 hour) and UV curing (20s, 60s, 100s)
b) aerosol assisted atmospheric plasma deposition.

Coatings obtained by the doctor blade technique were typically 10 to 30 micron thick. Coatings obtained by means of aerosol assisted atmospheric plasma deposition were typically 0.7 to 3 micron thick.

**Table 1. Curing behaviour and curing results of Bayresit/silane compositions**

| | ***Bayresit*/*Silane = 50:50*** | | **Bayresit/Silane = 20:80** | |
|---|---|---|---|---|
| **MEMO 22** | **UV** (NM 823) 20s, 60s, 100s: not/partly cured | **Plasma** (SO 180) cured film | **UV** (NM 810) 20s: not cured 60s, 100s: cured film | **Plasma** (SO 184) cured film |
| **GDMA 27** | **UV** (NM 825) 20s, 60s, 100s: not/partly cured | **Plasma** (SO 179) cured film | **UV** (NM 812) 20s: not cured 60s, 100s: cured film | Plasma (SO 186) cured film |
| **GLYMO 20** | **ΔT** (NM 826) 1h, 5h/130 °C: not cured | **Plasma** (SO 181) cured film | **ΔT** (NM 813 ) 1h, 5h/130 °C: not cured | **Plasma** (SO 185) cured film |
| **PTMO 10** | **ΔT** (NM 827) 1h, 5h/130 °C: not cured | **Plasma** (SO 182) cured film | ***No stable** solution* | |

Results of oxygen transmission rate (OTR) are given in the following tables/figures:

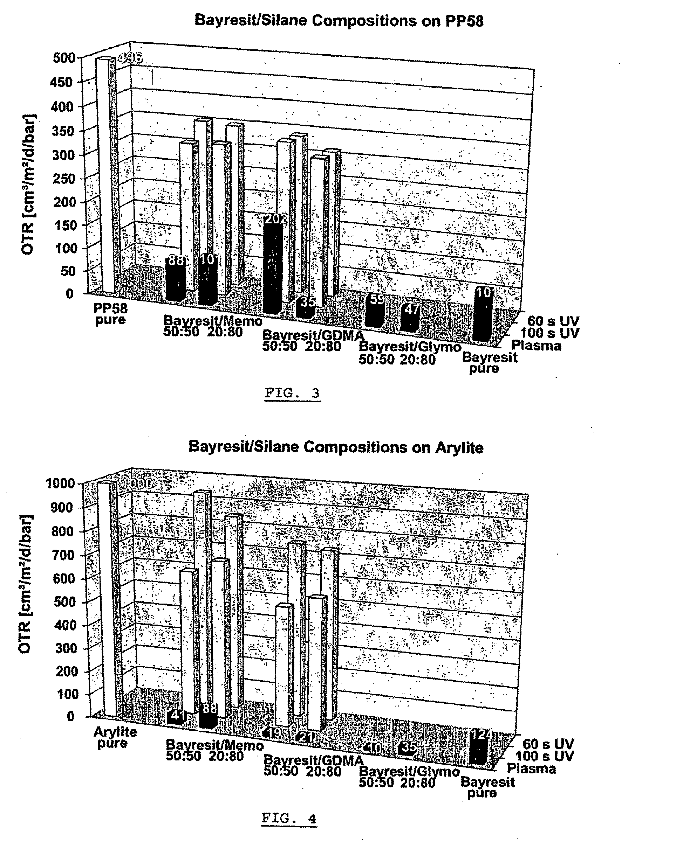

**Table 2. OTR data in cm³/m²/d•bar of Bayresit/silane compositions on PP58. These results are illustrated in fig. 3.**

| | ***Bayxesit*/*Silane = 50:50*** | | | **Bayresit/Silane = 20:80** | | |
|---|---|---|---|---|---|---|
| **MEMO 22** | **60s UV** 352 | **100s UV** 320 | **Plasma** 88 | **60s UV** 348 | **100s UV** 324 | **Plasma** 101 |
| **GDMA 27** | **60s UV** 338 | **100s UV** 341 | **Plasma** 202 | **60s UV** 311 | **100s UV** 314 | Plasma 35 |
| **GLYMO 20** | **ΔT** 1h, 5h/130 °C not cured | | **Plasma** | **ΔT** 1h, 5h/130 °C not cured | | **Plasma** |
| | No OTR measurement | | 59 | No OTR measurement | | 47 |
| **PTMO 10** | **ΔT** 1h, 5h/130 °C not cured | | **Plasma** | | | |
| | | | 108 | No stable solution | | |
| | No OTR measurement | | | | | |
| **TEOS 2** | - | | **Plasma** | **ΔT** 1h, 5h/130 °C **Plasma** not cured | | |
| | - | | | 79 | | |
| | | | | *No OTR* *measurement* | | |

**Table 3. OTR data in cm³/m²/d•bar of Bayresit/silane compositions on Arylite. These results are illustrated in fig. 4.**

| | ***Bayresit*/*Silane* = *50:50*** | | | **Bayresit/Silane = 20:80** | | |
|---|---|---|---|---|---|---|
| **MEMO 22** | **60s UV** 932 | **100s UV** 622 | **Plasma** 41 | **60s UV** 840 | **100s UV** 678 | **Plasma** 88 |
| **GDMA 27** | **60s UV** 748 | **100s UV** 512 | **Plasma** 19 | **60s UV** 730 | **100s UV** 562 | Plasma 21 |
| **GLYMO 20** | **ΔT** 1h, 5h/130 °C not cured | | **Plasma** | ΔT 1h, 5h/130 °C not cured | | **Plasma** |
| | | | 10 | | | 35 |
| | No OTR measurement | | | No OTR measurement | | |
| **PTMO 10** | **ΔT** 1h, 5h/130 °C not cured | | **Plasma** | | | |
| | | | 55 | No stable solution | | |
| | No OTR measurement | | | | | |
| **TEOS 2** | - | | **Plasma** | ΔT 1h, 5h/130 °C **Plasma** not cured | | |
| | - | | - | *22* | | |
| | | | | *No OTR* *measurement* | | |

| | | | | | | |
|---|---|---|---|---|---|---|
| OTR of PP58 pure: 562 cm³/m²/d•bar OTR of Arylite pure: >1000 cm³/m²/d•bar | | | | | | |

## Claims

1. A method for coating a substrate with an inorganic-organic hybrid polymer material using the Dielectric Barrier Discharge (DBD) technique, said method comprising the steps of:
a) introducing a sample in the space between two electrodes,
b) controlling the atmosphere between the electrodes,
c) generating a plasma discharge between the electrodes,
d) mixing aerosols containing hybrid organic/inorganic cross-linked pre-polymers formed via sol-gel processing, into the plasma discharge

2. A method as claimed in claim 1, in which one or more of the following additional components may be added to the plasma discharge: gases, vapors, aerosols or powders of non cross-linked precursor chemicals.

3. A method as claimed in either preceding claim in which the aerosol in step d) comprises a compositional gradient of the pre-polymers and/or any additional admixed components.

4. A method as claimed in any preceding claim, in which the plasma is maintained at a pressure from about 100Pa to about lMPa.

5. The method as claimed in claim 4, in which said plasma is maintained at a pressure from about 1kPa to about MPa.

6. The method according to claim 5, in which said plasma is maintained at about atmospheric pressure.

7. A method as claimed in any preceding claim, wherein the plasma is generated by alternating voltage between the electrodes of a frequency from about 10Hz to about 50MHz.

8. A method as claimed in any preceding claim, wherein the substrate comprises plastic, non-woven or woven fibers, natural, synthetic or semi-synthetic fibers, cellulosic material, metal, ceramic, powder or any composite structure thereof.

9. A method as claimed in any preceding claim, wherein the hybrid inorganic-organic coating increases, decreases and/or controls one or more of the following physical properties compared to the uncoated substrate: hydrophilic, hydrophobic, oleophilic, oleophobic, adhesive, release, gas diffusion barrier, liquid diffusion barrier, solids diffusion barrier, chemical resistance, UV resistance, thermal resistance, flame retardancy, porosity, conductivity, optical, self cleaning, acoustic, roughness, wear resistance, scratch resistance, lubricating, antimicrobial, biocompatible, sensory, catalytic properties, humidity, drug release, softness to touch, taste, smell, insect repelling properties, allergic reaction, toxicity, acid-base level.

10. A method as claimed in any preceding claim, in which the coating is an inorganic-organic hybrid polymer obtained and/or obtainable from an aerosol containing cross-linked inorganic-organic hybrid pre-polymer, formed via sol-gel processing.

11. A method as claimed in any preceding claim,, in which the inorganic-organic hybrid pre-polymer is obtained and/or obtainable from one or more of:. Tetramethoxysilane; Tetraethoxysilane; Zirconium-tetrapropoxide; Aluminium-tributoxide Titanium-tetraethoxide; Aluminium-dibutoxide ethylacetoacetate; Zirkonium-tripropoxide methylacrylate; Propyltrimethoxysilane; ;Phenyltrimethoxysilane; Diphenyldimethoxysilane; Mercaptopropyltrimethoxy-silane; Tridecafluoro-triethoxysilane; Aminopropyltriethoxy-silane; Trimethylammonium-propyltrimethoxysilane; Octadecyldimethylammonium-propyltrimethoxysilane; Vinylbenzyl ammoniumethyl aminopropyltrimethoxysilane; Succinic acid anhydride propyl triethoxysilane; Glycidoxypropyl-trimethoxysilane; vinyltrimethoxy-silane; Methacryloxypropyl-trimethoxysilane; TPGDA-silane; TEGDA-silane; BPADA-silane; GDMA-silane and/or; PETA-silane, silylated polymers, a compound defined by the formula : 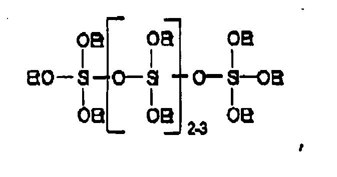 a compound defined by the formula : 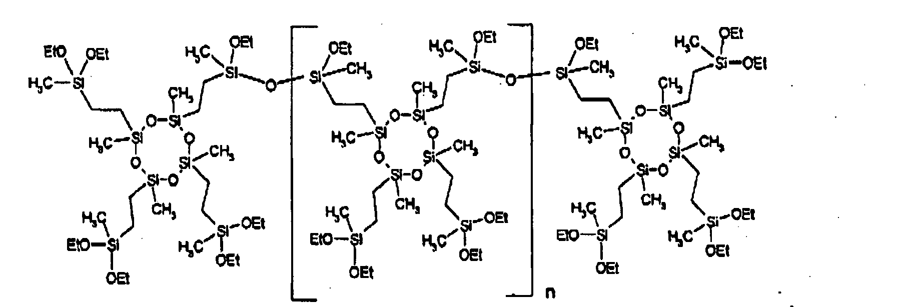 a compound defined by the formula : 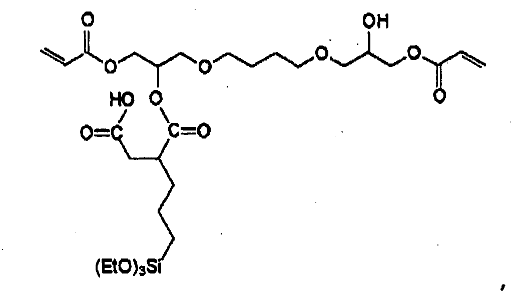 and/or suitable
mixtures thereof.

12. A method as claimed in any preceding claim, where the pre-polymer mixture in step d) further comprises
- inorganic coating forming materials selected from : colloidal metals, metal oxides, organometallic compounds and/or
- organic coating forming materials selected from : carboxylates, (meth)acrylates, styrenes, methacrylonitriles, alkenes and/or dienes, (meth)acrylic acid, fumaric acid (and esters), itaconic acid (and esters), maleic anhydride, halogenated alkenes, (metha)acrylonitrile, ethylene, propylene, allyl amine, vinylidene halides, butadienes, (meth)acrylamide, epoxy compounds, styrene oxide, butadiene monoxide, ethyleneglycol diglycidylether, glycidyl methacrylate, bisphenol A diglycidylether (and its oligomers), vinylcyclohexene oxide and phosphorus-containing compounds and/or any suitable mixtures thereof.

13. A method as claimed in any preceding claim, in which the inorganic-organic hybrid coating is obtained and/or obtainable by mixing separately in addition to the aerosol in step d) one or more additional gases, vapours, aerosols or powders of the following compounds to the plasma discharge: Ar, He, O₂, N₂, CO₂, CO, SF₅, NO, NO₂, N₂O, H₂, methane, ethane, propane, butane, ethylene, propylene, ethylene oxide, propylene oxide, acetylene, CF₄, C₂F₆, C₂F₄, H₂O and/or any of the ingredients described in claim 10.

14. A method as claimed in any preceding claim, in which the coating is applied as a liquid precursor.

15. A method as claimed in any preceding claim, in which the substrate which is coated is selected from, a powder, wire and a moving material web.

16. A coated substrate obtained and/or obtainable by a method as claimed in any preceding claim.

## Patentansprüche

1. Verfahren zum Beschichten eines Substrats mit einem anorganisch-organischen hybriden Polymermaterial, unter Anwendung der dielektrischen Barrierenentladungstechnik (Dielectric Barrier Discharge - DBD), wobei das Verfahren die folgenden Schritte umfasst:
a) Einbringen einer Probe in dem Raum zwischen zwei Elektroden,
b) Kontrollieren der Atmosphäre zwischen den Elektroden,
c) Erzeugen einer Plasmaentladung zwischen den Elektroden,
d) Mischen von Aerosolen, die hybride organische/anorganische querverbundene Prä-Polymere enthalten, die durch einen Sol-Gel-Prozess gebildet werden, in die Plasmaentladung.

2. Verfahren nach Anspruch 1, wobei eine oder mehrere der folgenden zusätzlichen Komponenten der Plasmaentladung zugegeben werden können: Gase, Dämpfe, Aerosole oder Pulver aus nicht querverbundenen Vorläuferchemikalien.

3. Verfahren nach einem der vorangehenden Ansprüche, in dem das Aerosol in Schritt d) einen Zusammensetzungsgradienten der Prä-Polymere und/oder zusätzliche beigemischte Komponenten umfasst.

4. Verfahren nach einem der vorangehenden Ansprüche, wobei das Plasma bei einem Druck von etwa 100 Pa bis etwa 1 MPa gehalten wird.

5. Verfahren nach Anspruch 4, wobei das Plasma bei einem Druck von etwa 1 kPa bis etwa 1 MPa gehalten wird.

6. Verfahren nach Anspruch 5, wobei das Plasma bei etwa atmosphärischem Druck gehalten wird.

7. Verfahren nach einem der vorangehenden Ansprüche, wobei das Plasma durch Alternieren der Spannung zwischen den Elektroden bei einer Frequenz von etwa 10 Hz bis etwa 50 MHz erzeugt wird.

8. Verfahren nach einem der vorangehenden Ansprüche, wobei das Substrat Kunststoff, ungewebte oder gewebte Fasern, natürliche, synthetische oder halb-synthetische Fasern, Zellulosematerial, Metall, Keramik, Pulver oder eine Verbundstruktur derselben umfasst.

9. Verfahren nach einem der vorangehenden Ansprüche, wobei die hybride anorganische-organische Beschichtung eine oder mehrere der folgernden physikalischen Eigenschaften im Vergleich zu dem unbeschichteten Substrat verstärkt, verringert und/oder kontrolliert: hydrophile, hydrophobe, oleophile, oleophobe, adhäsive, Freisetzungs-, Gasdiffusionsschranken-, Flüssigkeitsdiffusionsschranken-, Feststoffdiffusionsschranken-, chemische Beständigkeits-, UV-Beständigkeits-, Wärmebeständigkeits-, Flammhemmungs-, Porositäts-, Leitfähigkeits-, optische, selbst reinigende, akustische, Rauheits-, Abriebbeständigkeits-, Kratzfestigkeits-, Schmierungs-, antimikrobielle, biokompatible, sensorische, katalytische Eigenschaften, Feuchtigkeit, Arzneimittelfreisetzung, weicher Griff, Geschmack, Geruch, Insekten abweisende Eigenschaften, allergische Reaktion, Toxizität, Säure-Basen-Wert.

10. Verfahren nach einem der vorangehenden Ansprüche, wobei die Beschichtung ein anorganisch-organisches hybrides Polymer ist, das von einem Aerosol erhalten wird und/oder zu erhalten ist, das ein vernetztes anorganisch-organisches hybrides Prä-Polymer enthält, das durch einen Sol-Gel-Verfahren gebildet wird.

11. Verfahren nach einem der vorangehenden Ansprüche, wobei das anorganisch-organische hybride Prä-Polymer erhalten wird und/oder zu erhalten ist von einem oder mehreren der Folgenden: Tetramethoxysilan; Tetraethoxysilan; Zirconiumtetrapropoxid; Aluminiumtributoxid, Titantetraethoxid; Aluminium-Dibutoxid-Ethylacetoacetat; Zirconiumtripropoxid-Methylacrylat; Propyltrimethoxysilan; Phenyltrimethoxysilan; Diphenyldimethoxysilan; Mercaptopropyltrimethoxysilan; Tridecafluorotriethoxysilan;
Aminopropyltriethoxysilan; Trimethylammoniumpropyltrimethoxysilan; Octadecyldimethylammoniumpropyltrimethoxysilan; Vinylbenzyl-Ammoniumethyl-Aminopropyltrimethoxysilan; Bernsteinsäureanhydridpropyl-Triethoxysilan; Glycidoxypropyl-Trimethoxysilan; Vinyltrimethoxy-Silan; Methacryloxypropyl-Trimethoxysilan; TPGDA-Silan; TEGDA-Silan, BPADA-Silan; GDMA-Silan und/oder PETA-Silan, silylierte Polymere, eine durch folgende Formel definierte Verbindung: 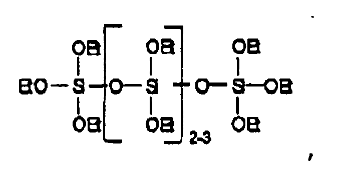 eine durch folgende Formel definierte Verbindung: 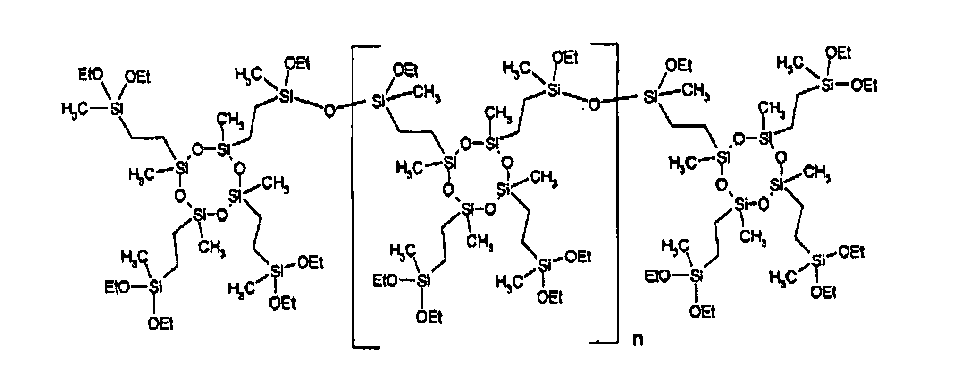 eine durch folgende Formel definierte Verbindung: 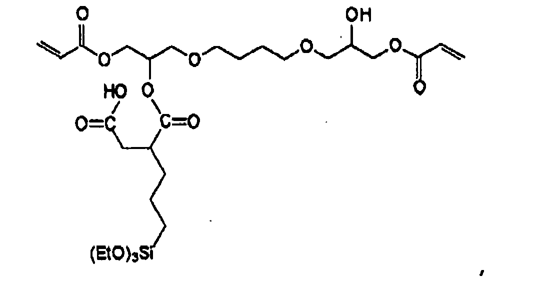 und/oder geeigneten Gemischen davon.

12. Verfahren nach einem der vorangehenden Ansprüche, wobei das Prä-Polymergemisch in Schritt d) des Weiteren umfasst
- anorganische Materialien, die eine Beschichtung bilden, ausgewählt aus: kolloidalen Metallen, Metalloxiden, organometallischen Verbindungen, und/oder
- organische Materialien, die eine Beschichtung bilden, ausgewählt aus: Carboxylaten, (Meth)Acrylaten, Styrolen, Methacrylonitrilen, Alkenen und/oder Dienen, (Meth)Acrylsäure, Fumarinsäure (und Ester), Itakonsäure (und Ester), Maleinsäureanhydrid, halogenierten Alkenen, (Metha)Acrylonitril, Ethylen, Propylen, Allylamin, Vinylidenhaliden, Butadienen, (Meth)Acrylamid, Epoxidverbindungen, Styroloxid, Butadienmonoxid, Ethylenglykol-Diglycidyläther, Glycidylmethacrylat, Bisphenol-A-diglycidyläther (und dessen Oligomeren) Vinylcyclohexenoxid und phosphorhältigen Verbindungen und/oder geeigneten Gemischen davon.

13. Verfahren nach einem der vorangehenden Ansprüche, wobei die anorganisch-organische hybride Beschichtung durch separates Mischen eines oder mehrerer zusätzlicher Gase, Dämpfe, Aerosole oder Pulver der folgenden Verbindungen: Ar, He, O₂, N₂, CO₂, CO, SF₆, NO, NO₂, N₂O, H₂, Methan, Ethan, Propan, Butan, Ethylen, Propylen, Ethylenoxid, Propylenoxid, Acetylen, CF₄, C₂F₆, C₂F₄, H₂O und/oder eines der Inhaltsstoffe, die in Anspruch 10 beschrieben sind, zu der Plasmaentladung zusätzlich zu dem Aerosol in Schritt d) erhalten wird und/oder zu erhalten ist.

14. Verfahren nach einem der vorangehenden Ansprüche, wobei die Beschichtung als flüssiger Vorläufer aufgetragen wird.

15. Verfahren nach einem der vorangehenden Ansprüche, wobei das Substrat, das aufgetragen wird, ausgewählt ist aus einem Pulver, einem Draht und einer laufenden Materialbahn.

16. Beschichtetes Substrat, das durch ein Verfahren nach einem der vorangehenden Ansprüche erhalten wird und/oder zu erhalten ist.

## Revendications

1. Procédé de revêtement d'un substrat avec un matériau polymère hybride organique-inorganique utilisant la technique de décharge contrôlée par barrière diélectrique (DBD), ledit procédé comprenant les étapes consistant à :
a) introduire un échantillon dans l'espace entre deux électrodes,
b) contrôler l'atmosphère entre les électrodes,
c) générer une décharge de plasma entre les électrodes,
d) mélanger des aérosols contenant des prépolymères réticulés organiques/inorganiques hybrides formés par le biais d'un traitement sol-gel dans la décharge plasma.

2. Procédé selon la revendication 1, dans lequel un ou plusieurs des composants supplémentaires suivants peuvent être ajoutés à la décharge plasma : des gaz, des vapeurs, des aérosols ou des poudres de produits chimiques précurseurs non réticulés.

3. Procédé selon l'une ou l'autre des revendications précédentes, dans lequel l'aérosol à l'étape d) comprend un gradient de composition des prépolymères et/ou l'un quelconque des composants mélangés supplémentaires.

4. Procédé selon l'une quelconque des revendications précédentes, dans lequel le plasma est maintenu à une pression d'environ 100 Pa à environ 1 MPa.

5. Procédé selon la revendication 4, dans lequel ledit plasma est maintenu à une pression d'environ 1 KPa à environ 1 MPa.

6. Procédé selon la revendication 5, dans lequel ledit plasma est maintenu aux alentours de la pression atmosphérique.

7. Procédé selon l'une quelconque des revendications précédentes, dans lequel le plasma est généré par une tension alternative entre les électrodes d'une fréquence d'environ 10 Hz à environ 50 MHz.

8. Procédé selon l'une quelconque des revendications précédentes, dans lequel le substrat comprend une matière plastique, des fibres tissées ou non tissées, des fibres naturelles, synthétiques ou semi-synthétiques, un matériau cellulosique, un métal, une céramique, une poudre ou une structure composite quelconque de ceux-ci.

9. Procédé selon l'une quelconque des revendications précédentes, dans lequel le revêtement organique-inorganique hybride augmente, diminue et/ou contrôle une ou plusieurs des propriétés physiques suivantes par rapport au substrat non revêtu : propriétés hydrophile, hydrophobe, oléophile, oléophobe, adhésive, anti-adhésive, barrière contre la diffusion de gaz, barrière contre la diffusion de liquide, barrière contre la diffusion de solide, résistance chimique, résistance aux UV, résistance thermique, ininflammabilité, porosité, conductivité, propriétés optique, autonettoyante, acoustique, rugosité, résistance à l'usure, résistance aux éraflures, propriétés lubrifiante, antimicrobienne, biocompatible, sensorielle, catalytique, humidité, libération de médicament, doux au toucher, agréable au goût, odeur agréable, propriétés insectifuges, réaction allergique, toxicité, niveau acido-basique.

10. Procédé selon l'une quelconque des revendications précédentes, dans lequel le revêtement est un polymère hybride organique-inorganique obtenu et/ou pouvant être obtenu à partir d'un aérosol contenant un prépolymère hybride organique-inorganique réticulé, formé par le biais d'un traitement sol-gel.

11. Procédé selon l'une quelconque des revendications précédentes, dans lequel le prépolymère hybride organique-inorganique est obtenu et/ou peut être obtenu à partir d'un ou plusieurs éléments suivants : le tétraméthoxysilane ; le tétraéthoxysilane ; le tétrapropoxyde de zirconium ; le tributoxyde d'aluminium tétraéthoxyde de titane ; le dibutoxyde d'aluminium acétoacétate d'éthyle ; le tripropoxyde de zirconium acrylate de méthyle ; le propyltriméthoxysilane ; le phényltriméthoxysilane ; le diphényldiméthoxysilane ; le mercaptopropyltriméthoxy-silane ; le tridécafluoro-triéthoxysilane ; l'aminopropyltriéthoxy-silane ; le triméthylammonium-propyltriméthoxysilane ;
l'octadécyldiméthylammonium-propyltriméthoxysilane ; le vinylbenzyl ammoniuméthyl aminopropyltriméthoxysilane ; l'anhydride d'acide succinique propyl triéthoxysilane ; le glycidoxypropyl-triméthoxysilane ; le vinyltriméthoxy-silane ; le méthacryloxypropyl-triméthoxysilane ; le TPGDA-silane ; le TEGDA-silane ; le BPADA-silane ; le GDMA-silane et/ou le PETA-silane, les polymères silylés, un composé défini par la formule : 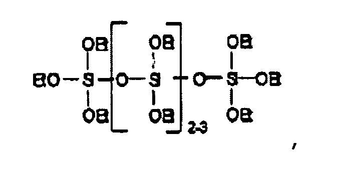 un composé défini par la formule : 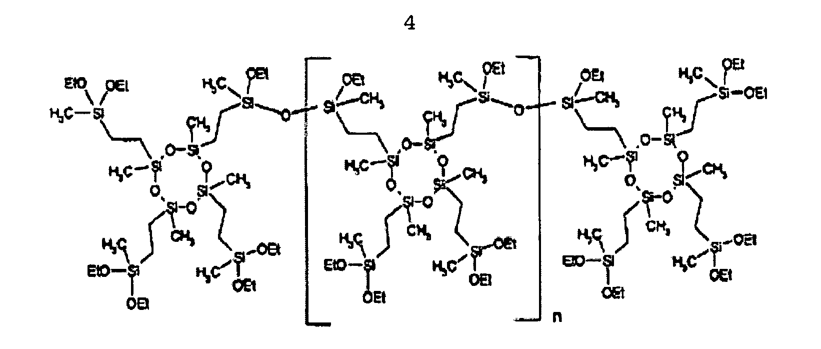 un composé défini par la formule : 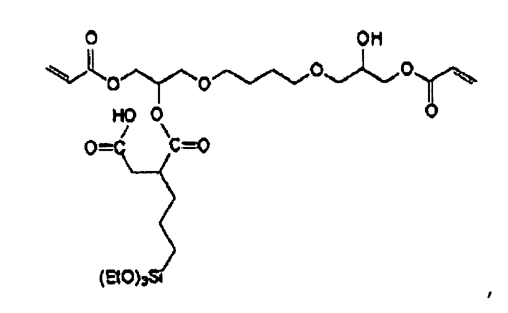 et/ou des mélanges appropriés de ceux-ci.

12. Procédé selon l'une quelconque des revendications précédentes, dans lequel le mélange de prépolymère à l'étape d) comprend en outre
- des matériaux de formation de revêtement inorganiques choisis parmi : les métaux colloïdaux, les oxydes de métal, les composés organométalliques et/ou
- des matériaux de formation de revêtement organiques choisis parmi : les carboxylates, les (méth)acrylates, les styrènes, les méthacrylonitriles, les alcènes et/ou les diènes, l'acide (méth)acrylique, l'acide fumarique (et les esters), l'acide itaconique (et les esters), l'anhydride maléique, les alcènes halogénés, le (métha) acrylonitrile, l'éthylène, le propylène, l'allyl amine, les halogénures de vinylidène, les butadiènes, le (méth)acrylamide, les composés époxy, l'oxyde de styrène, le monoxyde de butadiène, le diglycidyléther d'éthylèneglycol, le méthacrylate de glycidyle, le diglycidyléther de bisphénol A (et ses oligomères), l'oxyde de vinylcyclohexène et les composés contenant du phosphore et/ou des mélanges appropriés quelconques de ceux-ci.

13. Procédé selon l'une quelconque des revendications précédentes, dans lequel le revêtement hybride organique-inorganique est obtenu et/ou peut être obtenu en mélangeant séparément en plus de l'aérosol à l'étape d) un ou plusieurs gaz, vapeurs, aérosols ou poudres supplémentaires des composés suivants à la décharge plasma : Ar, He, O₂, N₂, CO₂, CO, SF₅, NO, NO₂ N₂O, H₂, le méthane, l'éthane, le propane, le butane, l'éthylène, le propylène, l'oxyde d'éthylène, l'oxyde de propylène, l'acétylène, CF₄, C₂F₆, C₂F₄, H₂O et/ou l'un quelconque des ingrédients décrits dans la revendication 10.

14. Procédé selon l'une quelconque des revendications précédentes, dans lequel le revêtement est appliqué en tant que précurseur liquide.

15. Procédé selon l'une quelconque des revendications précédentes, dans lequel le substrat qui est revêtu est choisi parmi une poudre, un fil et une bande de matériau mobile.

16. Substrat revêtu obtenu et/ou pouvant être obtenu par un procédé selon l'une quelconque des revendications précédentes.
